# EUROPÄISCHE PATENTSCHRIFT

(11) **EP 2 087 558 B1**
(45) Veröffentlichungstag und Bekanntmachung des Hinweises auf die Patenterteilung: **13.07.2016**
(21) Anmeldenummer: 07820572.1
(22) Anmeldetag: 26.09.2007
(51) Int. Cl.: H01R 13/53

(54) **ELEKTRISCHES ANSCHLUSSELEMENT**
ELECTRICAL CONNECTOR ELEMENT
ÉLÉMENT DE CONNEXION ÉLECTRIQUE

(30) Priorität: 06.11.2006 DE 102006052211
(43) Veröffentlichungstag der Anmeldung: 12.08.2009
(73) Patentinhaber: Siemens Aktiengesellschaft, 80333 München (DE)
(72) Erfinder: APPEL, Wilhelm, 2136 Laa a. d. Thaya (AT); EICHHORNER, Bernhard, 1210 Wien (AT); PEPRNY, Wolfgang, 1210 Wien (AT); PETRICEK, Martin, 2020 Hollabrunn (AT); SCHÖNLEITNER, Arnold, 1130 Wien (AT)
(74) Vertreter: Maier, Daniel Oliver
(86) Internationale Anmeldenummer: PCT/EP2007/060177
(87) Internationale Veröffentlichungsnummer: WO 2008/055746

(56) Entgegenhaltungen:
- EP-A- 1 006 617
- EP-A- 1 703 597
- DE-A1- 19 524 850
- DE-U1-202005 017 012

## Beschreibung

Die vorliegende Erfindung bezieht sich auf ein elektrisches Anschlusselement zum Anschluss eines Leiters an eine Leiterplatte bzw. an daran angeordnete Leiterbahnen, umfassend ein Gehäuse, mindestens einen Klemmanschluss für den Leiter sowie mindestens zwei Anschlusspins zur vorzugsweise lötbaren Verbindung mit der Leiterplatte bzw. den Leiterbahnen, gemäß dem Oberbegriff des Anspruchs 1 sowie eine Anordnung umfassend eine Leiterplatte mit einer Oberseite und einer Unterseite und ein an der Oberseite der Leiterplatte montierbares elektrisches Anschlusselement zum Anschluss eines Leiters, wobei das elektrische Anschlusselement ein Gehäuse, mindestens einen Klemmanschluss für den Leiter sowie mindestens zwei Anschlusspins zur vorzugsweise lötbaren Verbindung mit der Leiterplatte aufweist, und die Leiterplatte mit Aufnahmeöffnungen zur Aufnahme der Anschlusspins versehen ist, gemäß dem Oberbegriff des Anspruchs 10.

Elektrische Anschlusselemente finden in verschiedensten Ausführungsformen Anwendung, um einen zumeist kabelförmigen Leiter an eine Leiterplatte (auch als PCB, Printed Circuit Board, bezeichnet) bzw. an daran angeordneten Leiterbahnen anzuschließen.

Derartige elektrische Anschlusselemente sind auf der Leiterplatte mittels abstehender Kontaktelemente, im Folgenden Anschlusspins genannt, befestigt, welche in Montageposition elektrisch leitend mit an der Leiterplatte vorgesehenen, zugeordneten Leiterbahnen verbunden sind. Die Anschlusspins werden auch als Lötpins bezeichnet, weil sie üblicherweise in bereits in der Leiterplatte vorhandene Aufnahmeöffnungen bzw. Bohrungen eingreifen und anschließend mit der Leiterplatte verlötet werden.

Anschlusspins existieren in unzähligen Ausführungsvarianten und weisen zumeist einen runden oder rechteckigen Querschnitt auf.

Aufgrund der hohen Anordnungsdichte von an der Leiterplatte vorgesehenen Bauteilen ist eine möglichst kleine Dimensionierung auch der elektrischen Anschlusselemente erwünscht.

Die Reduzierung der Größe der elektrischen Anschlusselemente stößt jedoch aufgrund eines zwischen den einzelnen Anschlusspins notwendigen Sicherheitsabstandes an eine Grenze.

Derartige Sicherheitsabstände sind zumeist normgemäß vorgeschrieben, um einen Spannungsüberschlag und somit einen Kurzschluss zwischen benachbarten Anschlusspins sicher zu verhindern und variieren entsprechend der Höhe der am elektrischen Anschlusselement bzw. an den Anschlusspins anliegenden Spannung.

Die konkrete Spannung, welche notwendig ist, um Strom durch einen Isolator, bei gattungsgemäßen Leiterplatten-Anordnungen insbesondere zwischen den benachbarten Anschlusspins befindliche Luft, fließen zu lassen, ist im Wesentlichen proportional zur Länge des im Folgenden als "Spannungsstrecke" bezeichneten Weges, welchen die Elektronen durch den Isolator bzw. durch die Luft zurücklegen müssen, um von einem Anschlusspin zum nächst gelegenen Anschlusspin zu gelangen und einen Kurzschluss zu verursachen. Dementsprechend ist eine materialspezifische Durchschlagfestigkeit auch in der Einheit [V/mm] angegeben. Hierbei weist Kunststoff eine etwa zehn- bis vierzigfach höhere Durchschlagfestigkeit auf als das Medium Luft.

Der erwähnte Sicherheitsabstand entspricht bei konventionellen elektrischen Anschlusselementen der Spannungsstrecke, welche im Wesentlichen mit der Lücke zwischen zwei Anschlusspins gleichzusetzen ist. Genauer gesagt wird der Sicherheitsabstand bzw. die Spannungsstrecke üblicherweise als unmittelbarer Abstand zwischen den Außenmänteln zweier Anschlusspins auf einer in Normalrichtung zu den zumeist in Steckrichtung des elektrische Anschlusselementes verlaufenden Achsen der Anschlusspins gedachten Verbindungslinie gemessen, wobei ein solcherart gemessener Sicherheitsabstand auch als "Luftstrecke" bezeichnet wird.

Parallel dazu ist auch ein weiterer Sicherheitsabstand hinsichtlich einer "Kriechstrecke" definiert, welche der Strom entlang der Oberfläche der Leiterplatte zurücklegen muss, um von einem Anschlusspin zum nächsten zu gelangen. Der vorgeschriebene "Kriechstrecken"-Sicherheitsabstand ist zumeist wesentlich höher als der "Luftstrecken"-Sicherheitsabstand, da die Oberfläche der Leiterplatte im Laufe des Betriebs verschmutzen kann und der an der Oberfläche der Leiterplatte anhaftende Schmutz, gegebenenfalls in Kombination mit einem Vorliegen hoher Luftfeuchtigkeit und einer Kondensation der Luftfeuchte an der Leiterplatte, einen erleichterten Kurzschluss zwischen zwei Anschlusspins ermöglicht.

Die normgemäßen Sicherheitsabstände unterliegen neben der Leistungsklasse der elektrischen Anschlusselemente noch weiteren Faktoren wie etwa dem Einsatzgebiet der elektrischen Anschlusselemente, z.B. ob diese in Industrie- oder in Haushaltsnetzen eingesetzt ist.

Falls die Leiterplatte im Bereich der für die Aufnahme der Anschlusspins vorgesehenen Aufnahmeöffnungen noch metallische Einfassungen aufweist, so kann sich hierbei die effektive Spannungsstrecke bzw. "Kriechstrecke", welche der Strom zwischen zwei Anschlusspins zurücklegen muss, noch verringern. Auch die Schichtdicke des Lötmaterials, mittels welchem die Anschlusspins mit der Leiterplatte verlötet sind, ist hierbei zu berücksichtigen. Dokument DE 202005017012 offenbart ein Anschlusselement und eine Anordnung nach den Oberbegriffen der Ansprüche 1 und 10.

Der vorliegenden Erfindung liegt die Aufgabe zugrunde, die einzelnen Anschlusspins voneinander zu isolieren, um einen Spannungsüberschlag zwischen diesen zu verhindern. Insbesondere soll es ermöglicht werden, die Anschlusspins des elektrischen Anschlusselementes näher zueinander anzuordnen und somit eine kleinere Bauweise des elektrischen Anschlusselementes zu ermöglichen als dies bei konventionellen Anschlusselementen bzw. durch die Vorgabe der beschriebenen Sicherheitsabstände der Fall ist. Trotz der kleineren Beabstandung der Anschlusspins soll jedoch eine ausreichende Sicherheit gegenüber der Gefahr eines Spannungsüberschlags zwischen benachbarten Anschlusspins gewährleistet sein.

Erfindungsgemäß werden diese Ziele durch ein elektrisches Anschlusselement mit den kennzeichnenden Merkmalen des Anspruchs 1 sowie eine Anordnung mit den kennzeichnenden Merkmalen des Anspruchs 10 erreicht.

Auf diese Weise werden benachbarte Anschlusspins isolierend voneinander abgeschirmt bzw. die Durchschlagsfestigkeit jenes Bereichs zwischen zwei benachbarten Anschlusspins erhöht, welcher bei konventionellen elektrischen Anschlusselementen bisher nur durch das Medium Luft gebildet war.

Die Länge der Spannungsstrecke zwischen den Anschlusspins ergibt sich also bei einem erfindungsgemäßen elektrischen Anschlusselement nicht mehr in der oben beschriebenen Weise als ein linearer Normalabstand zwischen zwei Anschlusspins, sondern entspricht nun jenem hypothetischen Weg, welchen der an einem Anschlusspin anliegende Strom zur Überwindung bzw. Umrundung der Fläche des Trennelementes nehmen muss, um zum nächst benachbarten Anschlusspin zu gelangen.

Es versteht sich, dass das Trennelement hierbei eine gewisse Mindestdicke aufweisen muss, um nicht einem Spannungsdurchschlag zu unterliegen.

Durch Vorsehung eines erfindungsgemäßen Trennelementes kann also die Spannungsstrecke (sowohl die oben beschriebene "Kriechstrecke" als auch die "Luftstrecke") deutlich erhöht und die Abstände zwischen den Anschlusspins verringert werden, ohne dass daraus ein Sicherheitsrisiko bzw. eine Kurzschlussgefahr resultieren würde. Indem die Anschlusspins fortan näher zueinander benachbart sein können, wird der Platzbedarf des erfindungsgemäßen elektrischen Anschlusselementes gegenüber konventionellen elektrischen Anschlusselementen verringert. Durch die solcherart ermöglichte kleinere Fertigung des elektrischen Anschlusselementes ergibt sich zudem ein Kostenvorteil sowohl bei der Herstellung von Anschlusselementen und als auch bei der Herstellung von korrespondierenden Leiterplatten, welche ebenfalls kleiner dimensioniert werden können.

Gemäß den kennzeichnenden Merkmalen des Anspruchs 2, wonach das Trennelement in einer im Wesentlichen normalen Richtung von der Unterseite des Gehäuse absteht und gemäß den kennzeichnenden Merkmalen des Anspruchs 3, wonach das Trennelement in der Mitte zwischen zwei benachbarten Anschlusspins angeordnet ist und sich vorzugsweise in normaler Richtung zu einem Achsabstand zwischen den Anschlusspins erstreckt, wird eine Optimierung des Materialaufwands für die Trennelemente sowie eine einfach herstellbare Kompatibilität hinsichtlich der Steckbarkeit der Trennelemente in der Leiterplatte ermöglicht.

Indem die ab der Unterseite des Gehäuses gemessene, sich in Montageposition in Richtung der Leiterplatte erstreckende Länge des abstehenden Trennelementes sowie die entlang der Unterseite des Gehäuses verlaufende Breite des Trennelementes zufolge der kennzeichnenden Merkmale des Anspruchs 4 jeweils so gewählt sind, dass sowohl eine vom an den Anschlusspins anliegenden Strom zur Umrundung des Trennelementes zurückzulegende, einen Kurzschluss zwischen zwei benachbarten Anschlusspins verursachende "Luftstrecke" als auch eine vom Strom zur Umrundung des Trennelementes zurückzulegende, einen Kurzschluss zwischen zwei benachbarten Anschlusspins verursachende, entlang einer Unterseite der Leiterplatte sowie der Oberfläche des Trennelementes verlaufende "Kriechstrecke" jeweils mindestens so groß, vorzugsweise größer ist als ein korrespondierender normgemäßer "Luftstrecken"-Sicherheitsabstand bzw. ein "Kriechstrecken"-Sicherheitsabstand, wird ein Spannungsüberschlag zwischen benachbarten Anschlusspins sicher verhindert.

Das Trennelement kann gemäß den kennzeichnenden Merkmalen des Anspruchs 5 integral mit dem Gehäuse gefertigt sein. Auf diese Weise wird eine einfache und kostengünstige Herstellung ermöglicht.

Gemäß den kennzeichnenden Merkmalen des Anspruchs 6 ist das elektrische Anschlusselement aus Kunststoff gefertigt. Der Werkstoff Kunststoff weist allgemein eine hohe Isolierwirkung bzw. Durchschlagfestigkeit auf und eignet sich daher ganz besonders, um benachbarte Anschlusspins voneinander abzuschirmen.

Gemäß den kennzeichnenden Merkmalen des Anspruchs 7 ist das Trennelement in fertigungstechnisch einfacher Weise im Wesentlichen rechteckig ausgebildet. Die Rechtecksform weist vorzugsweise abgerundete oder gefaste Bereiche auf, um eine bessere Steckbarkeit der Trennelemente zu ermöglichen bzw. um Material einzusparen.

Um eine verbesserte Isolierwirkung zu erzielen, ist das Trennelement gemäß den kennzeichnenden Merkmalen des Anspruchs 8 schachtförmig ausgeführt, wobei eine beliebige Anzahl der Anschlusspins vom Trennelement in einer normal auf die Unterseite der Leiterplatte erfolgenden Draufsicht zumindest abschnittsweise umgeben ist.

Gemäß den kennzeichnenden Merkmalen des Anspruchs 9 ist es für den Fall, dass auf der Leiterplatte mehrere elektrische Anschlusselemente aneinandergrenzend angeordnet sind, auch möglich, an der Unterseite des Gehäuses eine beliebige Anzahl an zusätzlichen Trennelementen vorzusehen, welche zwischen den Anschlusspins eines ersten elektrischen Anschlusselementes und den Anschlusspins eines angrenzenden weiteren elektrischen Anschlusselementes angeordnet sind.

Das erfindungsgemäße Trennelement ist in einer bevorzugten Ausführungsweise gemäß den kennzeichnenden Merkmalen des Anspruchs 11 an einer der Leiterplatte zugewandten Unterseite des Gehäuses des elektrischen Anschlusselementes angeordnet und vorzugsweise integral mit dem Gehäuse gefertigt. Hierbei ist die Leiterplatte mit mindestens einer Zusatz-Aufnahmeöffnung versehen, durch welche sich das Trennelement hindurcherstreckt.

In einer alternativen Bauart gemäß den kennzeichnenden Merkmalen des Anspruchs 12 ist es jedoch auch möglich, das Trennelement an der einer Montageseite gegenüberliegenden Unterseite, der Leiterplatte anzuordnen und vorzugsweise integral mit der Leiterplatte auszuführen. Im Falle einer solchen Ausführungsweise kann es gegebenenfalls notwendig sein, zwischen der Oberseite der Leiterplatte und der Unterseite des Anschlusselement-Gehäuses eine isolierende Schicht z.B. aus Kunststoff vorzusehen, um in jenem Bereich einen Spannungsüberschlag zwischen zwei benachbarten Anschlusspins zu verhindern.

Analog zu Anspruch 2 erstreckt sich das in der erfindüngsgemäßen Anordnung vorgesehene Trennelement gemäß den kennzeichnenden Merkmalen des Anspruchs 13 in einer im Wesentlichen normalen Richtung zu einer von der Leiterplatte gebildeten Ebene, steht also senkrecht von der Unterseite des Gehäuses oder senkrecht von der Unterseite der Leiterplatte ab.

Analog zu Anspruch 3 ist das Trennelement gemäß den kennzeichnenden Merkmalen des Anspruchs 14 in der Mitte zwischen zwei benachbarten Anschlusspins angeordnet und erstreckt sich vorzugsweise in normaler Richtung zu einem Achsabstand zwischen den zwei Anschlusspins.

Analog zu Anspruch 4 ist die ab der Unterseite der Leiterplatte gemessene Länge des Trennelementes sowie die normal dazu verlaufende Breite des Trennelementes gemäß den kennzeichnenden Merkmalen des Anspruchs 15 jeweils so gewählt sind, dass sowohl eine vom an den Anschlusspins anliegenden Strom zur Umrundung des Trennelementes zurückzulegende, einen Kurzschluss zwischen zwei benachbarten Anschlusspins verursachende "Luftstrecke" als auch eine vom Strom zur Umrundung des Trennelementes zurückzulegende, einen Kurzschluss zwischen zwei benachbarten Anschlusspins verursachende, entlang der Unterseite der Leiterplatte sowie der Oberfläche des Trennelementes verlaufende "Kriechstrecke" jeweils mindestens so groß, vorzugsweise größer ist als der korrespondierende normgemäße "Kriechstrecken"-Sicherheitsabstand bzw. der "Luftstrecken"-Sicherheitsabstand.

Unter Erzielung der bereits zu Anspruch 6 angeführten Vorteile ist das Trennelement gemäß den kennzeichnenden Merkmalen des Anspruchs 16 aus Kunststoff gefertigt.

Analog zu Anspruch 7 ist das Trennelement gemäß den kennzeichnenden Merkmalen des Anspruchs 17 rechteckig ausgebildet, wobei die Rechtecksform auch abgerundet oder gefast sein kann.

Das Trennelement kann gemäß den kennzeichnenden Merkmalen des Anspruchs 18 schachtförmig ausgeführt sein, wobei eine beliebige Anzahl der Anschlusspins in einer normal auf die Unterseite der Leiterplatte erfolgenden Draufsicht zumindest abschnittsweise vom Trennelement umgeben ist.

Falls analog zu Anspruch 9 mehrere elektrische Anschlusselemente zueinander benachbart bzw. aneinandergrenzend auf der Leiterplatte angeordnet sind, kann gemäß den kennzeichnenden Merkmalen des Anspruchs 19 wiederum mindestens ein zusätzliches Trennelement vorgesehen sein, welches zwischen den Anschlusspins eines ersten elektrischen Anschlusselementes und den Anschlusspins eines angrenzenden zweiten elektrischen Anschlusselementes angeordnet ist und sich durch eine weitere Zusatz-Aufnahmeöffnung in der Leiterplatte hindurcherstreckt.

Die Erfindung wird nun anhand von Ausführungsbeispielen näher erläutert.

Dabei zeigt:
- Fig.1: eine schematische Darstellung einer erfindungsgemäßen Anordnung in axonometrischer Explosionsdarstellung
- Fig.2: eine schematische Darstellung einer erfindungsgemäßen Anordnung gemäß Fig.1 in montierter Position
- Fig.3: eine schematische Darstellung eines erfindungsgemäßen elektrischen Anschlusselementes in Schrägansicht
- Fig.4: eine schematische Darstellung eines erfindungsgemäßen elektrischen Anschlusselementes in Schrägansicht
- Fig.5: eine schematische Darstellung eines erfindungsgemäßen elektrischen Anschlusselementes in Schrägansicht
- Fig.6: eine geschnittene Seitenansicht eines erfindungsgemäßen elektrischen Anschlusselementes
- Fig.7: eine Vorderansicht eines mit einer Leiterplatte verlöteten erfindungsgemäßen elektrischen Anschlusselementes
- Fig.8: eine schematische Darstellung eines mit Aufnahmeöffnungen versehenen Bereichs einer Leiterplatte in Draufsicht

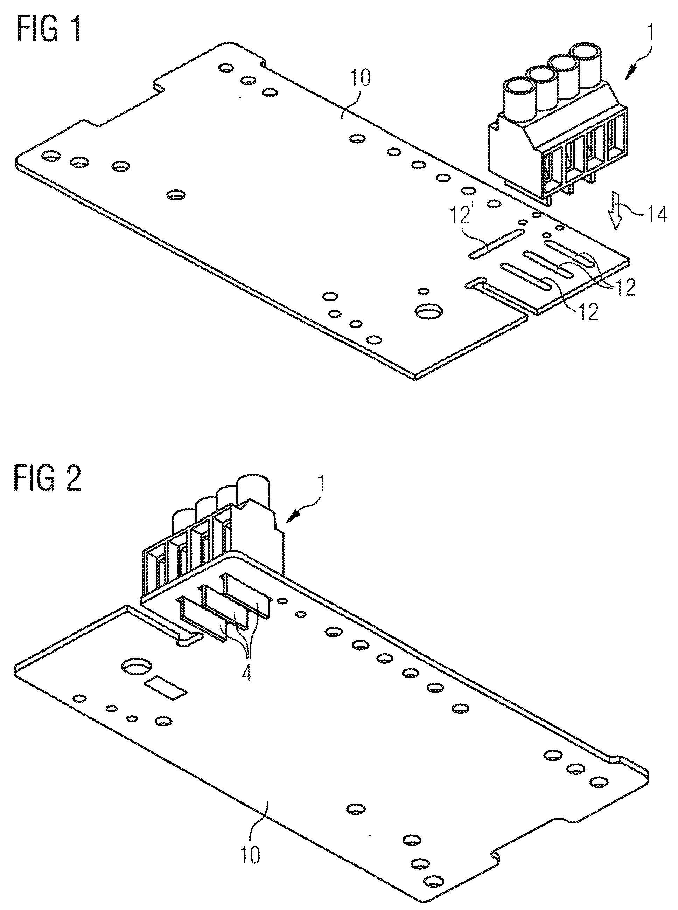

Fig.1 zeigt ein erfindungsgemäßes elektrisches Anschlusselement 1, welches manuell oder automatisiert in Steckrichtung 14 auf einer Leiterplatte 10 angebracht wird (siehe auch Fig.2).

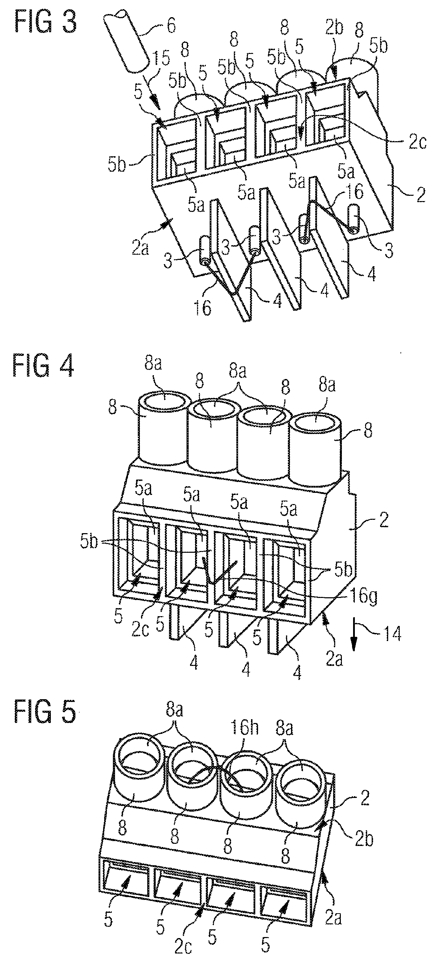

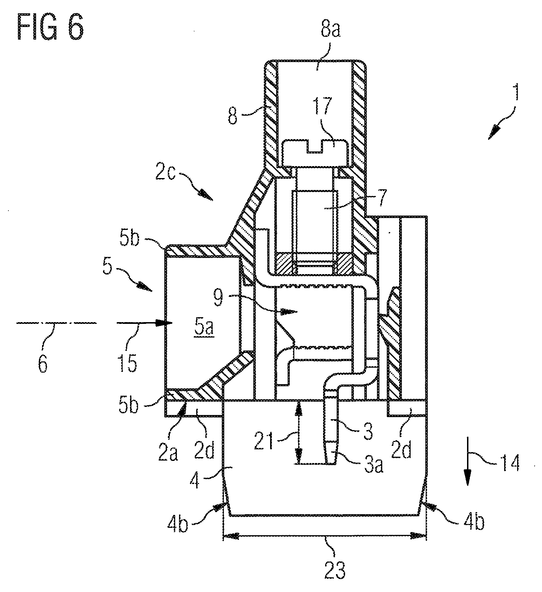

Das in den Figuren 3 bis 5 näher ersichtliche elektrische Anschlusselement 1 weist ein vorzugsweise aus Kunststoff gefertigtes Gehäuse 2 auf, welches an einer Frontseite 2c mit mehreren Klemmanschlüssen 5 versehen ist, wobei mittels stegartiger Wandungen 5b jeweils eine Aufnahme 5a ausgebildet ist. In die Aufnahme 5a des Klemmanschlusses 5 ist jeweils ein Leiter 6 in einer Einführrichtung 15 einsetzbar und mittels im Gehäuse 2 angeordneter Betätigungselemente 7 fixierbar (siehe Schnittdarstellung gemäß Fig.6).

Bei den Betätigungselementen 7 kann es sich beispielsweise um Schraub- oder Drückerelemente handeln, welche in an sich bekannter Weise eine Klemmung des in den Klemmanschluss 5 eingeführten Leiters 6 gegen einen im Gehäuse 2 angeordneten Klemmkäfig 9 bewirken.

Gemäß den Figuren 3 bis 5 weist das Gehäuse 2 an einer der Leiterplatte 10 in Montageposition abgewandten Oberseite 2b integral angeformte, zumeist röhrenförmige Formelemente 8 auf, welche jeweils eine Öffnung 8a ausbilden, in welche ein Werkzeug, z.B. ein Schraubendreher eingeführt werden kann, um die innerhalb des Gehäuses 2 angeordneten, den Leiter 6 freigebenden oder fixierenden Betätigungselemente 7 zu betätigen.

Aus einer in Montageposition der Leiterplatte 10 zugewandten Unterseite 2a des Gehäuses 2 ragt eine beliebige Anzahl an Anschlusspins 3 in der senkrecht zur Unterseite 2a verlaufenden Steckrichtung 14 heraus, welche zum Anschluss an nicht dargestellte Leiterbahnen der Leiterplatte 10 vorgesehen sind.

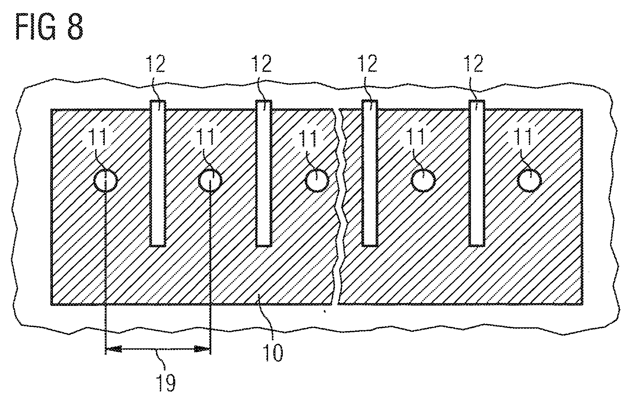

Bei den Anschlusspins 3 handelt es sich um dornförmig abstehende elektrische Kontakte, welche in korrespondierende Aufnahmeöffnungen 11 bzw. Bohrungen der Leiterplatte 10 eingreifen und anschließend mit dieser verlötet werden (siehe Fig.8).

Die Anschlusspins 3 können in verschiedenster Weise ausgestaltet sein und beispielsweise runde, rechteckige oder quadratische Querschnitte aufweisen. Üblicherweise werden die Anschlusspins 3 durch das Stanzen von flachem Material hergestellt.

Die übereinander angeordneten Klemmanschlüsse 5 und Anschlusspins 3 sind jeweils leitend miteinander verbunden. Der Anschlusspin 3 ist beispielsweise mit dem Klemmkäfig 9 des Klemmanschlusses 5 verbunden, durchdringt die Unterseite 2a des Gehäuses 2 und ragt über die Unterseite 2a mit einer Länge 21 hinaus (Fig.6).

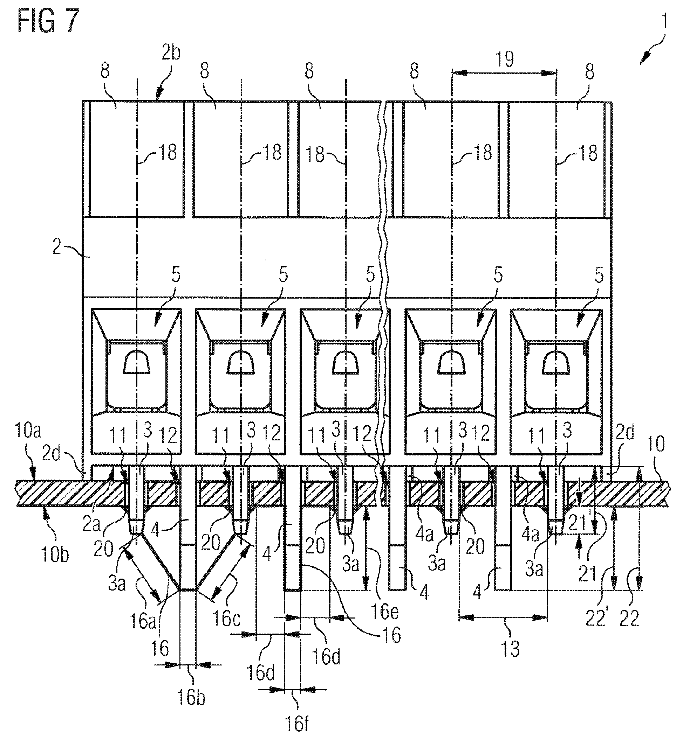

Das Verlöten des Anschlusspins 3 mit einem Lötmaterial 20 erfolgt üblicherweise auf einer dem aufgesteckten elektrischen Anschlusselement 1 abgewandten, auch als "Lötseite" bezeichneten Unterseite 10b der Leiterplatte 10, nachdem das elektrische Anschlusselement 1 auf einer auch als "Montageseite" bezeichneten Oberseite 10a der Leiterplatte 10 positioniert wurde und die Anschlusspins 3 im Bereich der Aufnahmeöffnungen 11 durch die Leiterplatte 10 hindurchragen (siehe Fig.7), um an dieser Stelle mit korrespondierenden an der Leiterplatte 10 vorgesehenen Leiterbahnen in elektrisch leitendem Kontakt zu stehen.

Anstelle einer Lötmontage kann das elektrische Anschlusselement 1 auch auf andere Weise an der Leiterplatte 10 befestigt sein, beispielsweise durch passgenaues Aufstecken.

Erfindungsgemäß ist das Gehäuse 2 des elektrischen Anschlusselementes 1 an seiner der Leiterplatte 10 zugewandten Unterseite 2a mit abstehenden Trennelementen 4 aus isolierendem Material versehen, welche zumindest abschnittsweise zwischen den Anschlusspins 3 angeordnet sind und in montierter Position in eigens dafür vorgesehene Zusatz-Aufnahmeöffnungen 12 der Leiterplatte 10 hinein- bzw. durch diese hindurchragen.

Die Trennelemente 4 erstrecken sich im vorliegenden Ausführungsbeispiel im Wesentlichen parallel zu den Anschlusspins 3 bzw. senkrecht zur Unterseite 2a des Gehäuses 2 und somit senkrecht zur Oberseite 10a bzw. Unterseite 10b der Leiterplatte 10, wobei das Trennelement 4 vorzugsweise in der Mitte zwischen zwei benachbarten Anschlusspins 3 angeordnet ist.

Auf diese Weise wird eine in Fig.3 ersichtliche Spannungsstrecke 16, worunter jener Weg verstanden wird, welchen die Elektronen im Falle eines Kurzschlusses zurücklegen müssen, um von einem Anschlusspin 3 zum nächst gelegenen Anschlusspin 3 zu gelangen, signifikant vergrößert. Während die Spannungsstrecke 16 bei einem konventionellen elektrischen Anschlusselement 1 im Wesentlichen einem Achsabstand 19 zwischen zwei benachbarten Anschlusspins 3, exakter gesagt, einer in Fig.7 eingezeichneten Lückenerstreckung 13 zwischen den Außenmänteln der Anschlusspins 3 entspricht, so setzt sich die Spannungsstrecke 16 im Falle der Vorsehung eines erfindungsgemäßen Trennelementes 4 aus Streckenabschnitten 16a, 16b und 16c bzw. 16d, 16e und 16f zusammen (ebenfalls in Fig.7 ersichtlich), welche in Summe jeweils einen längeren Weg ergeben als diesen der Stromfluss zur kurzschließenden Überwindung des Achsabstandes 19 bzw. der Lückenerstreckung 13 nehmen müsste.

Zur Herstellung eines Kurzschlusses kann der Stromfluss eine "Luftstrecke" einnehmen, welche im Wesentlichen der Summe der Streckenabschnitte 16a, 16b und 16c entspricht, oder auch eine "Kriechstrecke", welche im Wesentlichen der Summe der Streckenabschnitte 16d, 16e, 16f, 16e und 16 d entspricht und entlang der Unterseite 10b der Leiterplatte 10 und der Oberfläche des Trennelementes 4 verläuft. Wie Fig.7 zu entnehmen, kann hierbei zur Errechnung des entlang der Unterseite 10b der Leiterplatte 10 verlaufenden Streckenabschnitts 16d der "Kriechstrecke" nicht einfach der parallel zum Achsabstand 19 verlaufende Abstand zwischen Anschlusspin 3 und Trennelement 4 herangezogen werden, da die Breite des an der Leiterplatte 10 aufgebrachten elektrisch leitenden Lötmaterials 20 berücksichtigt bzw. vom Abstand zwischen Anschlusspin 3 und Trennelement 4 subtrahiert werden muss.

Sowohl die Summe der Streckenabschnitte 16a, 16b und 16c, also die "Luftstrecke", als auch die Summe der Streckenabschnitte 16d, 16e, 16f, 16e und 16 d, also die "Kriechstrecke" muss jeweils ausreichend groß, d.h., mindestens so groß sein wie die bereits einleitend beschriebenen, normgemäßen "Luftstrecken-" und "Kriechstrecken-" Sicherheitsabstände. Wesentlich ist also, dass die in Fig.7 ersichtliche Länge 22,22' ebenso wie die in Fig.6 ersichtliche Breite 23 des Trennelementes 4 so gewählt ist, dass dieses Erfordernis erfüllt ist, wobei sich die "Luftstrecke" und die "Kriechstrecke" nun nicht mehr als eine jeweils einzige lineare, sondern als eine zufolge des vom Trennelement 4 gebildeten "Hindernisses" diskontinuierliche, sich aus mehreren Streckenabschnitten zusammensetzende Strecke ergibt. Es versteht sich, dass sich die "Luftstrecke" sowie die "Kriechstrecke" bei anderer geometrischer Ausgestaltung des Trennelementes 4 als in Fig.7 abgebildet, gegebenenfalls auch aus anderen bzw. aus mehr Streckenabschnitten ergeben kann als im vorliegenden Ausführungsbeispiel dargestellt.

Konkret bedeutet die Vorsehung von erfindungsgemäßen Trennelementen 4, dass beispielsweise im Falle eines elektrischen Anschlusselementes 1 mit einer vorgesehenen Nennanschlussspannung von 600 V, wobei der normgemäße "Kriechstrecken-" Sicherheitsabstand bzw. die Lückenerstreckung 13 zwischen zwei Anschlusspins 3 gemäß einer US-Norm an sich mit 12,7 mm festgesetzt ist, diese Lückenerstreckung 13 bei voller Gewährleistung der Kurzschlusssicherheit nun auf etwa 6 mm reduziert werden kann. Erfindungsgemäße elektrische Anschlusselemente 1, welche für eine Nennspannung von 600 V vorgesehen sind, weisen z.B. einen Achsabstand 19 der Anschlusspins 3 von lediglich 6,35 mm auf, wobei der Anschlusspin-Durchmesser 1 mm beträgt.

Hierbei ist auch darauf zu achten, dass eine zwischen den Klemmanschlüssen 5 bzw. den Klemmkäfigen 9 weitere Spannungsstrecke 16g ausreichend groß ist, indem sich die Wandungen 5b, welche die Aufnahme 5a ausbilden, genügend weit von den leitenden Bauteilen des Klemmkäfigs 9 wegerstrecken. Gleichfalls müssen die Formelemente 8 tief genug bzw. eine weitere Spannungsstrecke 16h groß genug sein, um einen Spannungsüberschlag zwischen benachbarten Betätigungselementen 7, genauer gesagt zwischen den Köpfen 17 der Betätigungselemente 7, welche in den Öffnungen 8a der Formelemente 8 angeordnet sind, zu verhindern.

Um einen Spannungsdurchschlag durch das Trennelement 4 zu verhindern und auch, um ein Abbrechen der Trennelemente 4 während der Montage oder während des Betriebs des elektrischen Anschlusselementes 1, z.B. durch Erschütterungen zu verhindern, muss das Trennelement 4 eine gewisse Mindest-Wanddicke aufweisen. So beträgt die Wanddicke des Trennelementes 4, welche gemäß Fig.7 den Längen der Streckenabschnitte 16b bzw. 16f entspricht, im vorliegenden Ausführungsbeispiel etwa 0,95 mm.

Das erfindungsgemäße Trennelement 4 ist im Wesentlichen rechteckig ausgeführt, kann jedoch gemäß Fig.6 an seinen Eckbereichen auch Fasen 4b oder Abrundungen aufweisen, um eine optimale Steckbarkeit der Trennelemente 4 in die korrespondierenden Aufnahmeöffnungen 11 der Leiterplatte 10 zu ermöglichen. Auch die Anschlusspins 3 sind vorzugsweise mit einem konischen Endbereich 3a versehen, um eine bessere Steckbarkeit ebendieser in die Leiterplatte 10 zu ermöglichen.

Anstelle der dargestellten Rechtecksform kann das Trennelement 4 selbstverständlich auch in anderer Weise, beispielsweise schirmförmig bzw. konvex/konkav oder als Polygon ausgestaltet sein.

Falls die Anschlusspins 3 von der Unterseite 2a des Gehäuses 2 bzw. von einer dem Achsabstand 19 zwischen zwei Anschlusspins 3 entsprechenden Linie nicht senkrecht, sondern unter einem anderen Winkel abstehen, kann die Geometrie des Trennelementes 4 natürlich ebenfalls an diesen Verlauf der Anschlusspins 3 angepasst sein. Wesentlich ist jedenfalls stets, dass zwei benachbarte Anschlusspins 3 möglichst effektiv durch das Trennelement 4 voneinander separiert werden, indem der Spannungsabstand 16 zwischen den Anschlusspins 3 unter Ausnutzung der gesamten zur Verfügung stehenden Fläche des im vorliegenden Ausführungsbeispiel rechtwinkeligen Trennelementes 4 vergrößert wird.

An Stelle einer Anordnung des erfindungsgemäßen Trennelementes 4 am Gehäuse 2 des elektrischen Anschlusselementes 1 ist es ebenso denkbar, jenes an der Unterseite 10b der Leiterplatte 10 vorzusehen, wobei das Trennelement 4 entweder integral mit der Leiterplatte 10 ausgeführt oder auch als separater Bauteil an der Unterseite 10b der Leiterplatte 10 angebracht sein kann.

Im Falle einer solchen Ausführungsvariante ist lediglich dafür Sorge zu tragen, dass die Unterseite 2a des Gehäuses 2 und Oberseite 10a der Leiterplatte 10 einander dicht, also ohne Lufteinschluss kontaktieren, um in diesem Bereich die Gefahr eines Spannungsüberschlags zwischen den Anschlusspins 3 zu verhindern. Zu diesem Zweck kann im Zuge der Montage des elektrischen Anschlusselementes 1 auf der Leiterplatte 10 eine Materialschicht zwischen der Unterseite 2a des Gehäuses 2 und Oberseite 10a der Leiterplatte 10 vorgesehen sein, welche einen ausreichenden spezifischen Widerstand aufweist und im genannten Bereich etwaige Hohlräume zuverlässig ausfüllt, so etwa eine geeignete Kunststoff- oder Kleberschicht.

Unabhängig davon, ob das erfindungsgemäße Trennelement 4 nun am elektrischen Anschlusselement 1 oder an der Leiterplatte 10 angeordnet ist, erstreckt sich das abstehende Trennelement 4 im vorliegenden Ausführungsbeispiel mit einer ab der Unterseite 10b der Leiterplatte 10 gemessenen, senkrecht zu dieser verlaufenden Länge 22', welche größer, vorzugsweise doppelt so lang ist wie die über die Unterseite 10b der Leiterplatte 10 hinausragende Länge 21' des jeweils zum Trennelement 4 benachbarten Anschlusspins 3. Falls das Trennelement 4 fertigungstechnisch dem Gehäuse 2 des elektrischen Anschlusselementes 1 zugeordnet bzw. an diesem angeformt ist, so ist also eine in Fig.7 ersichtliche, ab der Unterseite 2a des Gehäuses 2 gemessene, sich in Montageposition in Richtung der Leiterplatte 10 erstreckende Länge 22 des Trennelementes 4 größer als eine Länge 21 eines zum Trennelement 4 benachbarten Anschlusspins 3.

Im vorliegenden Ausführungsbeispiel ragt der Anschlusspin 3 z.B. mit einer Länge 21' von 1,9 mm über die Unterseite 10b der Leiterplatte 10 hinaus, wobei die ab der Unterseite 10b der Leiterplatte 10 gemessene Länge 22' des Trennelementes 4 5,6 mm beträgt. Die Länge 22' des Trennelementes 4 überragt somit die Länge 21' des Anschlusspins 3 um 3,7 mm, ist also in etwa dreimal so groß wie diese. Aus diesen geometrischen Verhältnissen ergibt sich, dass die Summe der Streckenabschnitte 16a, 16b und 16c, also die "Luftstrecke", 9,7 mm beträgt, während die Summe der Streckenabschnitte 16d, 16e, 16f, 16e und 16 d, also die "Kriechstrecke", 16 mm beträgt. Auf diese Weise können die Anschlusspins 3 in platzsparender Weise mit einem Achsabstand 19 von 6,35 mm zueinander angeordnet werden, ohne dass ein Kurzschluss befürchtet werden muss.

Das Trennelement 4 ist im vorliegenden Ausführungsbeispiel genau in der Mitte zwischen zwei benachbarten Anschlusspins 3 angeordnet, wobei in der Seitenansicht gemäß Fig.6 ersichtlich ist, dass eine normal zur Längsachse 18 der Anschlusspins 3 bzw. normal zur in Fig.7 eingezeichneten Lückenerstreckung 13 verlaufende Breite 23 des Trennelementes 4 ebenfalls so gewählt ist, dass eine ausreichende abschirmende Wirkung des Trennelementes 4 gegeben ist. Der Anschlusspin 3 wird hierbei zweckmäßigerweise im Bereich der Mitte der Breite 23 des Trennelementes 4 (betrachtet in einer Seitenansicht gemäß Fig.6) angeordnet sein bzw. das Trennelement 4 wird hinsichtlich der Erstreckung seiner im Wesentlichen in normaler Richtung zur Lückenerstreckung 13 verlaufenden Breite 23 im Wesentlichen symmetrisch zum Anschlusspin 3 angeordnet sein.

Im Ausführungsbeispiel gemäß Fig.7 ist weiters ersichtlich, dass die Unterseite 2a des Gehäuses 2 nicht unmittelbar an der Oberseite 10a der Leiterplatte 10 anliegt, sondern mittels an der Unterseite 2a des Gehäuses 2 angeformten Stegabschnitten 2d bzw. mittels Schulterabschnitten 4a der Trennelemente 4, deren Durchmesser größer ist als jener der Aufnahmeöffnungen 11, von der Oberseite 10a der Leiterplatte 10 geringfügig distanziert ist.

Je nach spezifischer Konfiguration der auf der Leiterplatte 10 angeordneten Bauteile kann die erfindungsgemäße Idee der Vorsehung von Trennelementen 4 zwischen den Anschlusspins 3 abgewandelt werden, so können die Anschlusspins 3 auch noch gegenüber anderen Bereichen als dies in den vorliegenden Figuren 1-8 dargestellt ist, abgeschirmt werden.

Falls beispielsweise mehrere elektrische Anschlusselemente 1, 1' aneinandergrenzend auf der Leiterplatte 10 angeordnet sind, können ein oder mehrere zusätzliche Trennelemente 4' vorgesehen sein, welche die Anschlusspins 3 eines ersten elektrischen Anschlusselementes 1 und die Anschlusspins 3' eines dazu angrenzenden zweiten elektrischen Anschlusselementes 1' voneinander separieren (nicht dargestellt, siehe jedoch die schematische Darstellung einer weiteren Zusatz-Aufnahmeöffnung 12', welche zur Aufnahme eines zusätzlichen Trennelementes 4' vorgesehen ist, gemäß Fig.1).

Im solchem Falle mehrerer benachbarter elektrischer Anschlusselemente 1, 1' kann das mindestens eine zusätzliche Trennelement 4' auch in anderer Position angeordnet sein als dies in Fig.1 anhand der Zusatz-Aufnahmeöffnung 12' dargestellt ist. Das zusätzliche Trennelement 4' ist vorzugsweise in einem beliebigen Randbereich der Unterseite 2a des Gehäuses 2 angeordnet und kann beispielsweise auch in einem den Klemmanschlüssen 5 benachbarten Bereich des Gehäuses 2 angeordnet sein.

Der abschirmende bzw. isolierende Effekt der erfindungsgemäßen Trennelemente 4 kann auch gesteigert werden, indem das Trennelement 4 schachtförmig ausgeführt ist und solcherart eine beliebige Anzahl der Anschlusspins 3, betrachtet in einer normal auf die Unterseite 10b der Leiterplatte 10 erfolgenden Draufsicht, vom Trennelement 4 umgeben bzw. mit mehr oder weniger Abstand ummantelt wird (ebenfalls nicht dargestellt). Mit anderen Worten weist das Trennelement 4 in solchem Falle eine schachtförmige Aufnahme auf, innerhalb welcher ein Anschlusspin 3 angeordnet und von benachbarten Anschlusspins 3 separiert ist. Der Umfang der Anschlusspins 3 kann hierbei entweder (unter einer beliebigen Beabstandung zum Trennelement 4) abschnittsweise, im Falle einer Fertigung des Trennelementes 4 gemeinsam mit der Leiterplatte 10 sogar vollkommen vom Trennelement 4 umgrenzt sein. Insofern können das Trennelement 4 und das zusätzliche Trennelement 4' auch zumindest abschnittsweise ineinander übergehen und integral miteinander gefertigt sein.

Das erfindungsgemäße Trennelement 4 ist vorzugsweise aus Kunststoff gefertigt, da dieser mit 30-130 [kV/mm] eine hohe Isolierwirkung bzw. Durchschlagfestigkeit aufweist. Ebenso ist es jedoch denkbar, das Trennelement 4 aus anderen isolierenden Materialien, z.B. aus keramik- oder glashältigen Werkstoffen herzustellen.

Es versteht sich, dass ein gattungsgemäßes System auch noch zusätzliche abstehende Steckelemente und Aufnahmeöffnungen, welche entweder am elektrischen Anschlusselement 1 oder an der Leiterplatte 10 angeordnet sind, aufweisen kann, welche jedoch lediglich eine falsche Positionierung des elektrischen Anschlusselementes 1 auf der Leiterplatte 10 verhindern sollen und in ihrer Funktionalität nicht mit den erfindungsgemäßen Trennelementen 4 zu verwechseln sind.

Um sicherzustellen, dass zwischen den in den vorliegenden Figuren nicht dargestellten, von den Aufnahmeöffnungen 11 für die Anschlusspins 3 wegführenden Leiterbahnen der Leiterplatte 10 kein Spannungsüberschlag zufolge der den normgemäßen Sicherheitsabstand unterschreitenden, engen Anordnung der Anschlusspins 3 auftritt, kann es vorgesehen sein, dass diese von den Aufnahmeöffnungen 11 bzw. den Anschlusspins 3 wegführenden Leiterbahnen entweder in eine isolierte Schicht einer Multilayer-Leiterplatte führen und solcherart voneinander isoliert sind oder dass die Leiterplatte 10 zumindest bereichsweise mit einer zusätzlichen Isolierschicht überzogen ist.

## Patentansprüche

1. Elektrisches Anschlusselement (1) zum Anschluss wenigstens zweier Leiter (6) an eine Leiterplatte (10) bzw. an daran angeordnete Leiterbahnen, umfassend ein Gehäuse (2), mindestens zwei Anschlüsse (5) für die Leiter (6) sowie mindestens zwei Anschlusspins (3) zur vorzugsweise lötbaren Verbindung mit der Leiterplatte (10) bzw. den Leiterbahnen in einer Montageposition, wobei mindestens ein Trennelement (4) aus isolierendem Material vorgesehen ist, welche zumindest abschnittsweise zwischen den Anschlusspins (3) angeordnet ist und sich in Montageposition durch die Leiterplatte (10) hindurcherstreckt,
**dadurch gekennzeichnet, dass** die Anschlüsse als Klemmanschlüsse (5) mit jeweils einem Betätigungselement (8) und einem Klemmkäfig (9) ausgebildet sind, dass das Gehäuse (2) in seiner Montageposition an einer der Leiterplatte (10) zugewandten Unterseite (2a) das mindestens eine abstehende Trennelement (4) aufweist, und dass das Gehäuse (2) zu jedem Klemmanschluss (5) eine Wandung (5b) aufweist, welche eine Aufnahme (5a) für den Leiter (6) bildet, sowie ein Formelement 8 aufweist, welches eine Öffnung (8a) zur Betätigung des Betätigungselements (8) ausbildet, und dass des Weiteren die jeweilige Wandung (5b) sich weit genug vom jeweiligen Klemmkäfig (9) wegerstreckt und die Öffnung (8a) des Formelements 8 tief genug ist, um einen Spannungsüberschlag zwischen den leitenden Bauteilen der Klemmkäfige bzw. der Betätigungselemente zu verhindern.

2. Elektrisches Anschlusselement nach Anspruch 1,
**dadurch gekennzeichnet, dass** das Trennelement (4) in einer im Wesentlichen normalen Richtung von der Unterseite (2a) des Gehäuse (2) absteht.

3. Elektrisches Anschlusselement nach Anspruch 1 oder 2,
**dadurch gekennzeichnet, dass** das Trennelement (4) in der Mitte zwischen zwei benachbarten Anschlusspins (3) angeordnet ist und sich vorzugsweise in normaler Richtung zu einem Achsabstand (19) zwischen den Anschlusspins (3) erstreckt.

4. Elektrisches Anschlusselement nach einem der Ansprüche 1 bis 3, **dadurch gekennzeichnet, dass** die ab der Unterseite (2a) des Gehäuses (2) gemessene, sich in Montageposition in Richtung der Leiterplatte (10) erstreckende Länge (22) des abstehenden Trennelementes (4) sowie die entlang der Unterseite (2a) des Gehäuses (2) verlaufende Breite (23) des Trennelementes (4) jeweils so gewählt sind, dass sowohl eine vom an den Anschlusspins (3) anliegenden Strom zur Umrundung des Trennelementes (4) zurückzulegende, einen Kurzschluss zwischen zwei benachbarten Anschlusspins (3) verursachende "Luftstrecke" (16a,16b,16c) als auch eine vom Strom zur Umrundung des Trennelementes (4) zurückzulegende, einen Kurzschluss zwischen zwei benachbarten Anschlusspins (3) verursachende, entlang einer Unterseite (10b) der Leiterplatte (10) sowie der Oberfläche des Trennelementes (4) verlaufende "Kriechstrecke" (16d,16e,16f,16e,16d) jeweils mindestens so groß, vorzugsweise größer ist als ein korrespondierender normgemäßer "Luftstrecken"-Sicherheitsabstand bzw. ein "Kriechstrecken"-Sicherheitsabstand.

5. Elektrisches Anschlusselement nach einem der Ansprüche 1 bis 4, **dadurch gekennzeichnet, dass** das Trennelement (4) integral mit dem Gehäuse (2) gefertigt ist.

6. Elektrisches Anschlusselement nach einem der Ansprüche 1 bis 5, **dadurch gekennzeichnet, dass** das Trennelement (4) aus Kunststoff gefertigt ist.

7. Elektrisches Anschlusselement nach einem der Ansprüche 1 bis 6, **dadurch gekennzeichnet, dass** das Trennelement (4) eine vorzugsweise abgerundete oder gefaste Rechtecksform aufweist.

8. Elektrisches Anschlusselement nach einem der Ansprüche 1 bis 7, **dadurch gekennzeichnet, dass** das Trennelement (4) schachtförmig ausgeführt ist und eine beliebige Anzahl der Anschlusspins (3) zumindest abschnittsweise umgibt.

9. Elektrisches Anschlusselement nach einem der Ansprüche 1 bis 8, **dadurch gekennzeichnet, dass** das elektrische Anschlusselement (1) an der Unterseite (2a) des Gehäuses (2) mindestens ein zusätzliches Trennelement (4') aufweist, um die Anschlusspins (3) gegenüber den Anschlusspins (3) eines benachbarten weiteren auf der Leiterplatte (10) angeordneten elektrischen Anschlusselementes (1') zu isolieren.

10. Anordnung umfassend eine Leiterplatte (10) mit einer Oberseite (10a) und einer Unterseite (10b) und ein an der Oberseite (10a) der Leiterplatte (10) montierbares elektrisches Anschlusselement (1) zum Anschluss wenigstens zweier Leiter (6) an auf der Leiterplatte (10) angeordnete Leiterbahnen, wobei das elektrische Anschlusselement (1) ein Gehäuse (2), mindestens zwei Anschlüsse (5) für die Leiter (6) sowie mindestens zwei Anschlusspins (3) zur vorzugsweise lötbaren Verbindung mit der Leiterplatte (10) bzw. den Leiterbahnen aufweist, und die Leiterplatte (10) mit Aufnahmeöffnungen (11) zur Aufnahme der Anschlusspins (3) versehen ist, wobei
im montierten Zustand der Anordnung mindestens ein zumindest abschnittsweise zwischen den Anschlusspins (3) angeordnetes Trennelement (4) vorgesehen ist,
**dadurch gekennzeichnet, dass** das Gehäuse (2) zu jedem Klemmanschluss (5) eine Wandung (5b) aufweist, welche eine Aufnahme (5a) für den Leiter (6) bildet, sowie ein Formelement 8 aufweist, welches eine Öffnung (8a) zur Betätigung des Betätigungselements (8) ausbildet, und dass des Weiteren die jeweilige Wandung (5b) sich weit genug vom jeweiligen Klemmkäfig (9) wegerstreckt und die Öffnung (8a) des jeweiligen Formelements 8 tief genug ist, um einen Spannungsüberschlag zwischen den leitenden Bauteilen der Klemmkäfige bzw. der Betätigungselemente zu verhindern.

11. Anordnung nach Anspruch 10, , **dadurch gekennzeichnet, dass** das Trennelement (4) an einer der Leiterplatte (10) zugewandten Unterseite (2a) des Gehäuses (2) des elektrischen Anschlusselementes (1), vorzugsweise integral mit dem Gehäuse (2) gefertigt, angeordnet ist und die Leiterplatte (10) mit mindestens einer Zusatz-Aufnahmeöffnung (12) versehen ist, durch welche sich das Trennelement (4) hindurcherstreckt.

12. Anordnung nach Anspruch 10, **dadurch gekenn- zeichnet,** dass das Trennelement (4) an der einer Montageseite gegenüberliegenden Unterseite (10b) der Leiterplatte (10) angeordnet und vorzugsweise integral mit der Leiterplatte (10) ausgeführt ist.

13. Anordnung nach einem der Ansprüche 10 bis 12,
**dadurch gekennzeichnet, dass** sich das Trennelement (4) in einer im Wesentlichen normalen Richtung zu einer von der Leiterplatte (10) gebildeten Ebene erstreckt.

14. Anordnung nach einem der Ansprüche 10 bis 13,
**dadurch gekennzeichnet, dass** das Trennelement (4) in der Mitte zwischen zwei benachbarten Anschlusspins (3) angeordnet ist und sich vorzugsweise in normaler Richtung zu einem Achsabstand (19) zwischen den Anschlusspins (3) erstreckt.

15. Anordnung nach einem der Ansprüche 10 bis 14,
**dadurch gekennzeichnet, dass** die ab der Unterseite (10b) der Leiterplatte (10) gemessene Länge (22') des abstehenden Trennelementes (4) sowie die normal dazu verlaufende verlaufende Breite (23) des Trennelementes (4) jeweils so gewählt sind, dass sowohl eine vom an den Anschlusspins (3) anliegenden Strom zur Umrundung des Trennelementes (4) zurückzulegende, einen Kurzschluss zwischen zwei benachbarten Anschlusspins (3) verursachende "Luftstrecke" (16a,16b,16c) als auch eine vom Strom zur Umrundung des Trennelementes (4) zurückzulegende, einen Kurzschluss zwischen zwei benachbarten Anschlusspins (3) verursachende, entlang der Unterseite (10b) der Leiterplatte (10) sowie der Oberfläche des Trennelementes (4) verlaufende "Kriechstrecke" (16d, 16e, 16f, 16e, 16d) jeweils mindestens so groß, vorzugsweise größer ist als ein korrespondierender normgemäßer "Kriechstrecken"-Sicherheitsabstand bzw. ein "Luftstrecken"-Sicherheitsabstand.

16. Anordnung nach einem der Ansprüche 10 bis 15,
**dadurch gekennzeichnet, dass** das Trennelement (4) aus Kunststoff gefertigt ist.

17. Anordnung nach einem der Ansprüche 10 bis 16,
**dadurch gekennzeichnet, dass** das Trennelement (4) eine vorzugsweise abgerundete oder gefaste Rechtecksform aufweist.

18. Anordnung nach einem der Ansprüche 10 bis 17,
**dadurch gekennzeichnet, dass** das Trennelement (4) schachtförmig ausgeführt ist und eine beliebige Anzahl der Anschlusspins (3) in einer normal auf die Unterseite (10b) der Leiterplatte (10) erfolgenden Draufsicht zumindest abschnittsweise umgibt.

19. Anordnung nach einem der Ansprüche 10 bis 18,
**dadurch gekennzeichnet, dass** mehrere elektrische Anschlusselemente (1, 1') benachbart auf der Leiterplatte (10) angeordnet sind und mindestens ein zusätzliches Trennelement (4') vorgesehen ist, welches zwischen den Anschlusspins (3) eines ersten elektrischen Anschlusselementes (1) und den Anschlusspins (3') eines angrenzenden zweiten elektrischen Anschlusselementes (1') angeordnet ist und sich durch eine weitere Zusatz-Aufnahmeöffnung (12') in der Leiterplatte (10) hindurcherstreckt.

## Claims

1. Electrical connector element (1) for connecting at least two conductors (6) to a printed circuit board (10) or to conductor tracks disposed thereon, comprising a housing (2), at least two connectors (5) for the conductors (6) and at least two connector pins (3) for preferably solderable connection to the printed circuit board (10) or conductor tracks in an assembled position, with at least one separating element (4) made of an insulating material being provided, at least part of which is disposed between the connector pins (3) and which extends through the printed circuit board (10) in the assembled position,
**characterised in that** the connectors are configured as clamp connectors (5), each with an actuation element (8) and a clamping cage (9), in its assembled position the housing (2) has the at least one projecting separating element (4) on a lower face (2a) facing the printed circuit board (10) and at each clamp connector (5) the housing (2) has a wall (5b), which forms a holder (5a) for the conductor (6), and has a moulded element (8), which forms an opening (8a) for actuation of the actuation element (8), and the respective wall (5b) also extends sufficiently far away from the respective clamping cage (9) and the opening (8a) of the moulded element (8) is deep enough to prevent flashover between the conducting components of the clamping cage and/or the actuation elements.

2. Electrical connector element according to claim 1,
**characterised in that** the separating element (4) projects in an essentially normal direction from the lower face (2a) of the housing (2).

3. Electrical connector element according to claim 1 or 2,
**characterised in that** the separating element (4) is disposed in the centre between two adjacent connector pins (3) and preferably extends in a normal direction to an axial distance (19) between the connector pins (3).

4. Electrical connector element according to one of claims 1 to 3, **characterised in that** the length (22) of the separating element (4) measured from the lower face (2a) of the housing (2) and extending in the direction of the printed circuit board (10) in the assembled position and the width (23) of the separating element (4) running along the lower face (2a) of the housing (2) respectively are selected in such a manner that both an "air path" (16a, 16b, 16c) to be covered by the current present at the connector pins (3) to travel round the separating element (4) and causing a short circuit between two adjacent connector pins (3) and a "creepage path" (16d, 16e, 16f, 16e, 16d) running along a lower face (10b) of the printed circuit board (10) and the upper face of the separating element (4) to be covered by the current to travel round the separating element (4) and causing a short circuit between two adjacent connector pins (3) respectively are at least as large, preferably larger than a corresponding "air path" safe distance required by standard and/or a "creepage path" safe distance.

5. Electrical connector element according to one of claims 1 to 4, **characterised in that** the separating element (4) is produced as an integral part of the housing (2).

6. Electrical connector element according to one of claims 1 to 5, **characterised in that** the separating element (4) is made of plastic.

7. Electrical connector element according to one of claims 1 to 6, **characterised in that** the separating element (4) has a preferably rounded or chamfered rectangular form.

8. Electrical connector element according to one of claims 1 to 7, **characterised in that** the separating element (4) is embodied in the form of a shaft and surrounds any number of the connector pins (3) at least partially.

9. Electrical connector element according to one of claims 1 to 8, **characterised in that** the electrical connector element (1) has at least one additional separating element (4') on the lower face (2a) of the housing (2) to insulate the connector pins (3) from the connector pins (3) of an adjacent further electrical connector element (1') disposed on the printed circuit board (10).

10. Arrangement comprising a printed circuit board (10) with an upper face (10a) and a lower face (10b) and an electrical connector element (1) that can be assembled on the upper face (10a) of the printed circuit board (10) to connect at least two conductors (6) to conductor tracks disposed on the printed circuit board (10), the electrical connector element (1) having a housing (2), at least two connectors (5) for the conductors (6) and at least two connector pins (3) for preferably solderable connection to the printed circuit board (10) and/or the conductor tracks, and the printed circuit (10) board being provided with openings (11) to hold the connector pins (3),
with at least one separating element (4) disposed at least partially between the connector pins (3) in the assembled state of the arrangement being provided,
**characterised in that** at each clamp connector (5) the housing (2) has a wall (5b), which forms a holder (5a) for the conductor (6), and has a moulded element (8), which forms an opening (8a) for actuation of the actuation element (8), and the respective wall (5b) also extends sufficiently far away from the respective clamping cage (9) and the opening (8a) of the respective moulded element (8) is deep enough to prevent flashover between the conducting components of the clamping cage and/or the actuation elements.

11. Arrangement according to claim 10, **characterised in that** the separating element (4) is disposed on a lower face (2a) of the housing (2) of the electrical connector element (1) facing the printed circuit board (10) and is preferably produced so that it is an integral part of the housing (2), and the printed circuit board (10) is provided with at least one additional opening (12), through which the separating element (4) extends.

12. Arrangement according to claim 10, **characterised in that** the separating element (4) is disposed on a lower face (10b) of the printed circuit board (10) opposite an assembly face and is preferably embodied as an integral part of the printed circuit board (10).

13. Arrangement according to one of claims 10 to 12,
**characterised in that** the separating element (4) extends in an essentially normal direction to a plane formed by the printed circuit board (10).

14. Arrangement according to one of claims 10 to 13,
**characterised in that** the separating element (4) is disposed in the centre between two adjacent connector pins (3) and extends preferably in a normal direction to an axial distance (19) between the connector pins (3).

15. Arrangement according to one of claims 10 to 14,
**characterised in that** the length (22') of the projecting separating element (4) measured from the lower face (10b) of the printed circuit board (10) and the width (23) of the separating element (4) running normal to this respectively are selected in such a manner that both an "air path" (16a, 16b, 16c) to be covered by the current present at the connector pins (3) to travel round the separating element (4) and causing a short circuit between two adjacent connector pins (3) and a "creepage path" (16d, 16e, 16f, 16e, 16d) running along the lower face (10b) of the printed circuit board (10) and the upper face of the separating element (4) to be covered by the current to travel round the separating element (4) and causing a short circuit between two adjacent connector pins (3) respectively are at least as large, preferably larger than a corresponding "creepage path" safe distance required by standard and/or an "air path" safe distance.

16. Arrangement according to one of claims 10 to 15,
**characterised in that** the separating element (4) is made of plastic.

17. Arrangement according to one of claims 10 to 16,
**characterised in that** the separating element (4) has a preferably rounded or chamfered rectangular form.

18. Arrangement according to one of claims 10 to 17,
**characterised in that** the separating element (4) is embodied in the form of a shaft and surrounds any number of the connector pins (3) at least partially in a plan view normal to the lower face (10b) of the printed circuit board (10).

19. Arrangement according to one of claims 10 to 18,
**characterised in that** a number of electrical connector elements (1, 1') are disposed in an adjacent manner on the printed circuit board (10) and at least one additional separating element (4') is provided, which is disposed between the connector pins (3) of a first electrical connector element (1) and the connector pins (3') of an adjoining second electrical connector element (1') and extends through a further additional opening (12') in the printed circuit board (10).

## Revendications

1. Elément de connexion électrique (1) pour la connexion au moins de deux conducteurs (6) à une plaquette à circuit imprimé (10) resp. à des circuits conducteurs disposés dessus, comprenant un boîtier (2), au moins deux raccords (5) pour les conducteurs (6) ainsi qu'au moins deux broches de raccordement (3) pour la liaison de préférence soudable à la plaquette à circuit imprimé (10) resp. aux circuits conducteurs dans une position de montage, au moins un élément de séparation (4) en matière isolante étant ménagé, lequel est disposé au moins par sections entre les broches de raccordement (3) et s'étend à travers la plaquette à circuit imprimé (10) en position de montage, **caractérisé en ce que** les raccords sont réalisés comme raccords de serrage (5) munis respectivement d'un élément d'actionnement (8) et d'une cage de serrage (9), **en ce que** le boîtier (2) présente, dans sa position de montage, sur un côté inférieur (2a) tourné vers la plaquette à circuit imprimé (10), l'au moins un élément de séparation (4) en saillie, et **en ce que** le boîtier (2) présente une paroi (5b) vers chaque raccord de serrage (5), laquelle forme un logement (5a) pour le conducteur (6), et présente un élément formé 8, lequel forme une ouverture (8a) pour l'actionnement de l'élément d'actionnement (8), et **en ce qu'**en outre la paroi respective (5b) s'étend en s'éloignant suffisamment de la cage de serrage respective (9) et **en ce que** l'ouverture (8a) de l'élément formé 8 est suffisamment profonde pour empêcher une décharge de tension entre les composants conducteurs des cages de serrage resp. des éléments d'actionnement.

2. Elément de connexion électrique selon la revendication 1, **caractérisé en ce que** l'élément de séparation (4) est en saillie du côté inférieur (2a) du boîtier (2) dans une direction essentiellement normale.

3. Elément de connexion électrique selon la revendication 1 ou 2, **caractérisé en ce que** l'élément de séparation (4) est disposé au milieu entre deux broches de raccordement voisines (3) et s'étend entre les broches de raccordement (3) de préférence en direction normale par rapport à un entraxe (19).

4. Elément de connexion électrique selon l'une quelconque des revendications 1 à 3, **caractérisé en ce que** la longueur (22) de l'élément de séparation (4) en saillie, mesurée à partir du côté inférieur (2a) du boîtier (2), s'étendant en direction de la plaquette à circuit imprimé (10) en position de montage, ainsi que la largeur (23) de l'élément de séparation (4), s'étendant le long du côté inférieur (2a) du boîtier (2), sont respectivement sélectionnées de manière à ce qu'aussi bien un « trajet aérien » (16a, 16b, 16c) à parcourir par le courant appliqué aux broches de raccordement (3) pour faire le tour de l'élément de séparation (4), provoquant un court-circuit entre deux broches de raccordement voisines (3), qu'un « trajet de fuite » (16d, 16e, 16f, 16e, 16d) à parcourir par le courant appliqué aux broches de raccordement (3) pour faire le tour de l'élément de séparation (4), provoquant un court-circuit entre deux broches de raccordement voisines (3), s'étendant le long d'un côté inférieur (10b) de la plaquette à circuit imprimé (10) ainsi que de la surface de l'élément de séparation (4) sont respectivement aussi grands, de préférence plus grands, qu'un écart de sécurité de « trajet aérien » correspondant normalisé resp. qu'un écart de sécurité de « trajet de fuite ».

5. Elément de connexion électrique selon l'une quelconque des revendications 1 à 4, **caractérisé en ce que** l'élément de séparation (4) est fabriqué de manière intégrale avec le boîtier (2).

6. Elément de connexion électrique selon l'une quelconque des revendications 1 à 5, **caractérisé en ce que** l'élément de séparation (4) est fabriqué en matière plastique.

7. Elément de connexion électrique selon l'une quelconque des revendications 1 à 6, **caractérisé en ce que** l'élément de séparation (4) présente une forme rectangulaire de préférence arrondie ou biseautée.

8. Elément de connexion électrique selon l'une quelconque des revendications 1 à 7, **caractérisé en ce que** l'élément de séparation (4) est réalisé en forme de puits et **en ce qu'**il entoure au moins par sections un nombre quelconque des broches de raccordement (3).

9. Elément de connexion électrique selon l'une quelconque des revendications 1 à 8, **caractérisé en ce que** l'élément de connexion électrique (1) présente sur le côté inférieur (2a) du boîtier (2) au moins un élément de séparation supplémentaire (4') afin d'isoler les broches de raccordement (3) par rapport aux broches de raccordement (3) d'un élément de connexion électrique (1') supplémentaire voisin disposé sur la plaquette à circuit imprimé (10).

10. Agencement comprenant une plaquette à circuit imprimé (10), munie d'un côté supérieur (10a) et d'un côté inférieur (10b), et un élément de connexion électrique (1) pouvant être monté sur le côté supérieur (10a) de la plaquette à circuit imprimé (10) pour la connexion au moins de deux conducteurs (6) à des circuits conducteurs disposés sur la plaquette à circuit imprimé (10), l'élément de connexion électrique (1) présentant un boîtier (2), au moins deux raccords (5) pour les conducteurs (6) ainsi qu'au moins deux broches de raccordement (3) pour la liaison de préférence soudable à la plaquette à circuit imprimé (10) resp. aux circuits conducteurs, et la plaquette à circuit imprimé (10) étant munie d'ouvertures de logement (11) pour le logement des broches de raccordement (3),
au moins un élément de séparation (4) disposé au moins par sections entre les broches de raccordement (3) étant ménagé, à l'état monté de l'agencement,
**caractérisé en ce que** le boîtier (2) présente une paroi (5b) vers chaque raccord de serrage (5), laquelle forme un logement (5a) pour le conducteur (6), ainsi qu'un élément formé 8, lequel forme une ouverture (8a) pour l'actionnement de l'élément d'actionnement (8) et **en ce qu'**en outre la paroi respective (5b) s'étend en s'éloignant suffisamment de la cage de serrage respective (9) et **en ce que** l'ouverture (8a) de l'élément formé respectif 8 est suffisamment profonde pour empêcher une décharge de tension entre les composants conducteurs des cages de serrage resp. des éléments d'actionnement.

11. Agencement selon la revendication 10, **caractérisé en ce que** l'élément de séparation (4) est disposé sur un côté inférieur (2a), tourné vers la plaquette à circuit imprimé (10), du boîtier (2) de l'élément de connexion électrique (1), de préférence en étant fabriqué de manière intégrale avec le boîtier (2), et **en ce que** la plaquette à circuit imprimé (10) est munie d'au moins une ouverture de logement supplémentaire (12) à travers laquelle s'étend l'élément de séparation (4).

12. Agencement selon la revendication 10, **caractérisé en ce que** l'élément de séparation (4) est disposé sur le côté inférieur (10b), opposé à un côté de montage, de la plaquette à circuit imprimé (10) et est réalisé de préférence de manière intégrale avec la plaquette à circuit imprimé (10).

13. Agencement selon l'une quelconque des revendications 10 à 12, **caractérisé en ce que** l'élément de séparation (4) s'étend dans une direction essentiellement normale par rapport à un plan formé par la plaquette à circuit imprimé (10).

14. Agencement selon l'une quelconque des revendications 10 à 13, **caractérisé en ce que** l'élément de séparation (4) est disposé au milieu entre deux broches de raccordement voisines (3) et s'étend entre les broches de raccordement (3) de préférence en direction normale par rapport à un entraxe (19).

15. Agencement selon l'une quelconque des revendications 10 à 14, **caractérisé en ce que** la longueur (22') de l'élément de séparation (4) en saillie, mesurée à partir du côté inférieur (10b) de la plaquette à circuit imprimé (10), ainsi que la largeur (23) de l'élément de séparation (4), s'étendant normalement par rapport à celui-ci, sont respectivement sélectionnées de manière à ce qu'aussi bien un « trajet aérien » (16a, 16b, 16c) à parcourir par le courant appliqué aux broches de raccordement (3) pour faire le tour de l'élément de séparation (4), provoquant un court-circuit entre deux broches de raccordement voisines (3), qu'un « trajet de fuite » (16d, 16e, 16f, 16e, 16d) à parcourir par le courant appliqué aux broches de raccordement (3) pour faire le tour de l'élément de séparation (4), provoquant un court-circuit entre deux broches de raccordement voisines (3), s'étendant le long du côté inférieur (10b) de la plaquette à circuit imprimé (10) ainsi que de la surface de l'élément de séparation (4) sont respectivement aussi grands, de préférence plus grands, qu'un écart de sécurité de « trajet aérien » correspondant normalisé resp. qu'un écart de sécurité de « trajet de fuite ».

16. Agencement selon l'une quelconque des revendications 10 à 15, **caractérisé en ce que** l'élément de séparation (4) est fabriqué en matière plastique.

17. Agencement selon l'une quelconque des revendications 10 à 16, **caractérisé en ce que** l'élément de séparation (4) présente une forme rectangulaire arrondie ou biseautée.

18. Agencement selon l'une quelconque des revendications 10 à 17, **caractérisé en ce que** l'élément de séparation (4) est réalisé en forme de puits et **en ce qu'**il entoure au moins par sections un nombre quelconque des broches de raccordement (3) dans une vue de dessus réalisée normalement sur le côté inférieur (10b) de la plaquette à circuit imprimé (10).

19. Agencement selon l'une quelconque des revendications 10 à 18, **caractérisé en ce que** plusieurs éléments de connexion électrique (1, 1') sont disposés de manière voisine sur la plaquette à circuit imprimé (10) et **en ce qu'**au moins un élément de séparation supplémentaire (4') est ménagé, lequel est disposé entre les broches de raccordement (3) d'un premier élément de connexion électrique (1) et les broches de raccordement (3') d'un deuxième élément de connexion électrique voisin (1'), et **en ce qu'**il s'étend dans la plaquette à circuit imprimé (10) à travers une ouverture de logement supplémentaire (12').
